# EUROPEAN PATENT APPLICATION

(11) **EP 1 650 321 A2**
(43) Date of publication of application: **26.04.2006**
(21) Application number: 04028515.7
(22) Date of filing: 02.12.2004
(51) Int. Cl.: C23C 14/34, H01J 37/34

(54) **A sputtering system**

(30) Priority: 30.09.2004 US 955889
(71) Applicant: Applied Films Corporation, Longmont, CO 80504 (US)
(72) Inventor: Newcomb, Richard, Johnstown Colorado 80304 (US); Nilsen, Oyvind, Erie Colorado 80304 (US)
(74) Representative: Schickedanz, Willi

(57) **Abstract**

A rotatable target for sputtering is described. This target can include a target backing tube having an exterior surface; a backing layer in contact with the exterior surface of the target backing tube, the backing layer being electrically conductive and thermally nonconductive; and a plurality of target cylinders located around the target backing tube and in contact with the backing layer.

## Description

### FIELD OF THE INVENTION

The present invention relates to a sputtering system. In particular, but not by way of limitation, the present invention relates to non-bonded rotatable targets usable for sputtering.

### BACKGROUND OF THE INVENTION

Glass is irreplaceable in a broad range of applications, such as window panes, automotive glazing, displays, and TV or computer monitor tubes. Glass possesses a unique combination of properties: it is transparent, dimensionally and chemically stable, highly scratch resistant, non-polluting, and environmentally beneficial. Nonetheless glass can be improved, particularly its optical and thermal properties

Vacuum coating is the technology of choice for adapting glass surfaces and other surfaces to suit specialized requirements or demanding applications. Vacuum coating is capable of depositing ultra-thin, uniform films on large-area substrates. Vacuum-coating technology is also the least polluting of current coating technologies. Notably, vacuum coating can be used to coat materials other than glass, including plastics and metal.

Common vacuum-coating systems sputter conductive and dielectric material from rotating magnetrons onto a substrate such as glass, plastic, or metal. Rotating magnetrons driven by direct current (DC) have been known for several years. And recently magnetrons driven by high-voltage alternating current (AC) have been introduced. These AC systems are advantageous but have been plagued by reliability and expense problems.

One problem with rotating magnetrons involves the target assembly, which includes the material being sputtered. Depending upon the application, target assemblies can be formed of several different materials. And these materials vary significantly in their behavior. Certain materials, for example, are subject to thermal expansion and cracking. Unfortunately, when a target assembly cracks, it often must be replaced, even though it still may have significant amounts of sputtering material left on it. And with certain target assemblies, nodules could form on them and again force premature replacement.

Premature replacement of target assemblies and any reduced performance in sputtering caused by damaged target assemblies results in significant extra costs to manufacturers and consumers. And although present targets and target assemblies are functional, they can be improved.

### SUMMARY OF THE INVENTION

Exemplary embodiments of the present invention that are shown in the drawings are summarized below. These and other embodiments are more fully described in the Detailed Description section. It is to be understood, however, that there is no intention to limit the invention to the forms described in this Summary of the Invention or in the Detailed Description. One skilled in the art can recognize that there are numerous modifications, equivalents and alternative constructions that fall within the spirit and scope of the invention as expressed in the claims.

In one exemplary embodiment, the present invention can include a rotatable sputtering target. This target includes a target backing tube having an exterior surface; a backing layer in contact with the exterior surface of the target backing tube, the backing layer being electrically conductive and thermally non-conductive; and a plurality of target cylinders located around the target backing tube and in contact with the backing layer.

### BRIEF DESCRIPTION OF THE DRAWINGS

Various objects and advantages and a more complete understanding of the present invention are apparent and more readily appreciated by reference to the following Detailed Description and to the appended claims when taken in conjunction with the accompanying Drawings wherein:
FIGURE 1 is a diagram of a prior-art, cantilevered, rotating-magnetron system;
FIGURE 2 is a diagram of a prior-art, dual-supported, rotating-magnetron system;
FIGURE 3 is a block diagram of a prior-art, rotating-magnetron system;
FIGURE 4 is a block diagram of a target constructed according to one implementation of the present invention; and
FIGURE 5 is a cross section of one target assembly;
FIGURE 6 is a cross section of another target assembly; and
FIGURE 7 is a cross section of yet another target assembly.

### DETAILED DESCRIPTION

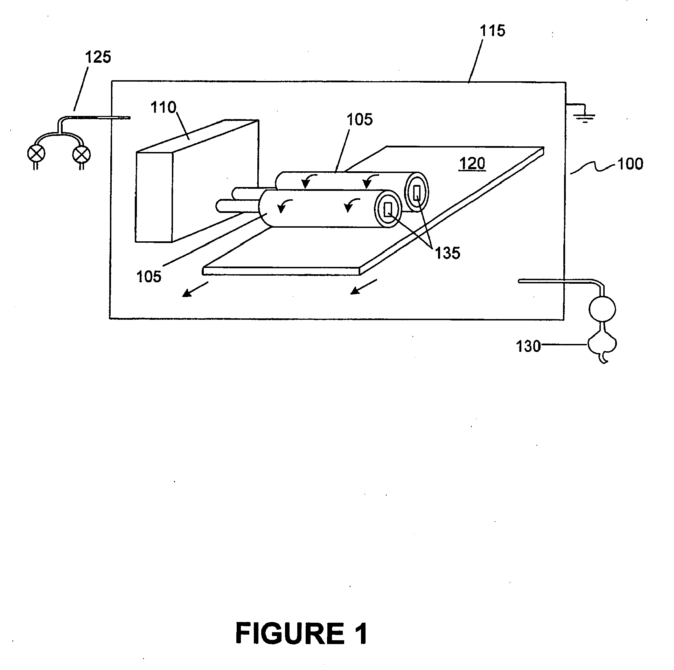

Referring now to the drawings, where like or similar elements are designated with identical reference numerals throughout the several views, and referring in particular to FIGURE 1, it illustrates a prior-art, cantilevered, rotating-magnetron system 100. This system 100 includes dual rotating cylindrical target assemblies 105 that are rotated by a drive system 110. The tubes 105 are coated with a target material that is sputtered using plasma formed inside the vacuum chamber 115. The sputtered target material is deposited on the substrate 120.

The plasma is formed inside the vacuum chamber 115 by exciting a gas that is introduced into the vacuum chamber 115 at an inlet 125 and removed through an outlet 130. The sputtering effect is focused using a stationary magnet system 135 mounted inside the target assemblies 105. An exemplary system is described in Japanese Laid-Open Patent Application 6-17247 ("Haranou") entitled *High-efficiency alternating-current magnetron sputtering device,* assigned to Asahi Glass.

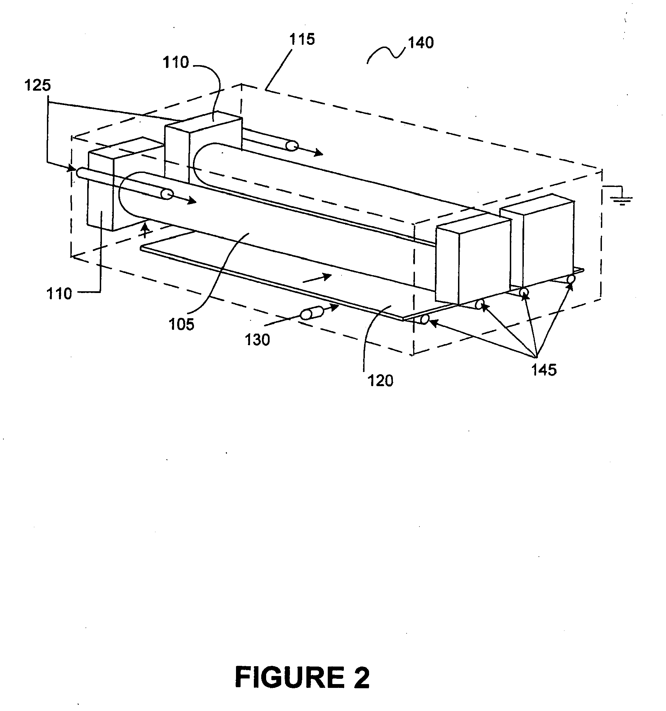

Referring now to Figure 2, it is a diagram of a prior-art, dual-supported, rotating-magnetron system 140. This system includes a vacuum chamber 115, a gas inlet 125, a gas outlet 130, a drive system 110, a power system (not shown), and two target assemblies 105 covered with a target material. This target material is sputtered onto the substrate 120 that is being moved through the vacuum chamber by the substrate drive motors 145.

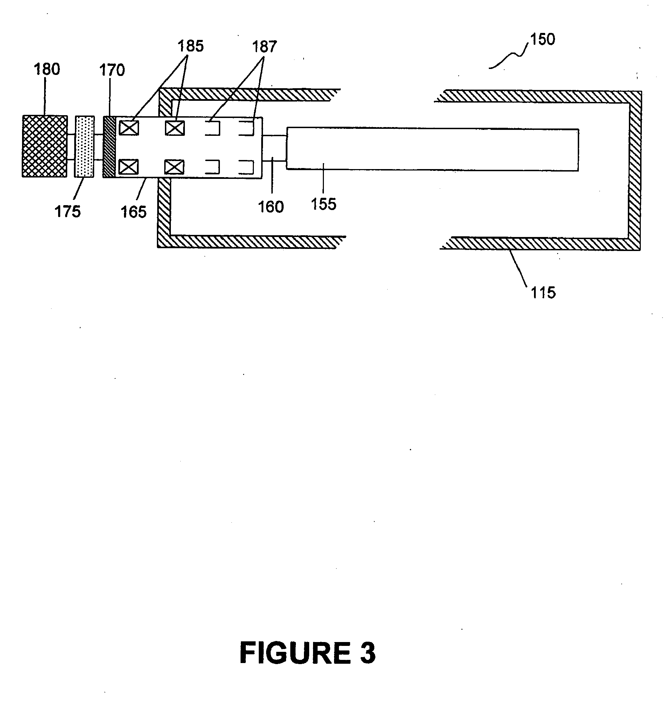

Referring now to Figure 3, it is a block diagram of a prior-art, rotating-magnetron system 150. This system includes a target assembly 155 connected to a shaft 160. This shaft 160 is connected to a bearing and seal assembly 165, a power coupling 170, and a rotation drive 175. The shaft 160 is also coupled to a water supply 180 so that water can be pumped through the shaft 160 and used to conductively cool the bearing and seal assembly 165 and the target tube 155. The water is sufficient to cool the bearings 185 and the seals 187 in certain systems but not always in high-power systems. In these high-power systems, the bearings 185 tend to overheat, lose lubricant, and seize.

Seals 187 are used to maintain the pressure differential between the outside world and the inside of the vacuum chamber 115. Traditionally, these seals have been ferrofluidic seals, which are costly and difficult to maintain. In particular, the ferro-fluid in the seals is subject to inductive heating in high-power AC systems. To prevent the seals from failing, they often require water cooling and high-temperature ferro-fluid ― both of which add significant complexity and expense to the seal.

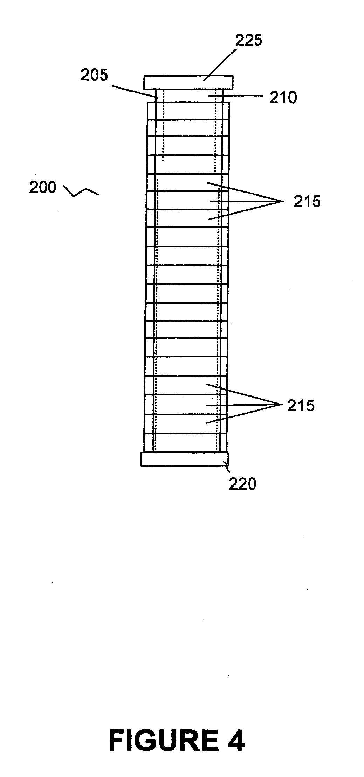

Referring now to Figure 4, it illustrates a target assembly 200 constructed according to one embodiment of the present invention. This target assembly 200 includes a target backing tube 205, backing material 210, and non-bonded target material formed of adjacently-located cylindrical target portions 215. Each of these components is described below.

The target backing tube 205, in this embodiment, includes a thermally conductive tube and two stops (220, 225), one located on each end of the tube. Generally, one stop is fixed and the other is removable. Although in some embodiments, both stops are removable, and in other embodiments both stops are fixed. And in yet another embodiment, one of the stops is loaded with the tension of a spring to cause the cylindrical target portions 215 to be in close contact. With this set up, the cylindrical target portions 215 may expand due to the heat load caused by the sputtering process, but no gaps occur between the single cylindrical target portions 215. By this means, damage to the backing material 210 caused by the magnetron plasma is prevented. Furthermore, a potential sputtering of the backing material 210 out of a gap between the cylindrical target portions 215 will not occur and contamination will be prevented.

In another embodiment, the target backing tube 205 is constructed of a non-thermally-conductive material. A backing material 210 can be placed over the outside circumference of the target backing tube 205. The backing material 210 is generally electrically conductive and thermally non-conductive. The backing material 210 is often thermally non-conductive to reduce or eliminate the amount of contact cooling of the cylindrical target portions 215 caused by water flowing through the inside of the target backing tube 205. For many target materials, a reduction in contact cooling is important to prevent the target material from cracking and to resist the tendency for nodule formation.

The backing material 210 can include a fiber mesh (or paper composed of a material such as graphite), such as a graphite mesh, applied to the length of the target backing tube 205. The mesh could be secured to the backing tube 205 by a mechanical or chemical fastener. Alternatively, the mesh could be secured only by friction.

In another embodiment, the backing material 210 could be attached directly to the inside surface of the cylindrical target portions 215. For example, a graphite mesh could be attached to the inside surface of the cylindrical target portions 215. The rings could be joined by the mesh or the rings could remain separated by individual mesh portions.

Typical target material includes any ceramic, conductive, oxide targets, including, but not limited to, indium tin oxide (ITO), aluminum zinc oxide, etc. Other target materials are known to those of skill in the art. Similarly, the thermal and structural properties of these materials are known to those of skill in the art.

Still referring to Figure 4, the cylindrical target portions 215 are not bonded to the target backing tube 205. By not bonding the cylindrical target portions 215 to the target backing tube, the target surface is allowed to heat sufficiently that combined with the rotary motion of the target which sputters the entire surface area, the build up of nodules on the surface of the cylindrical target portions 215 is greatly reduced or eliminated.

One further advantage of note is that presently-known target assemblies bond the target material to the backing tube with indium solder or other alloy. This is costly, time consuming and has several drawbacks. For example, the solder material can flow out between the gaps of the target and therefore contaminate the sputtered film. Further, the solder in these old systems is not evenly distributed such that there are voids that create a large thermal gradient over a small area of the target and typically results in cracking. But the design of this implementation of the present invention reduces or eliminates these drawbacks.

This implementation of the cylindrical target portions 215 comes in at least two configurations: single cylinder and multiple-adjacent cylinders. The single cylinder embodiment includes a single cylinder that is roughly the length of the target backing tube. In other embodiments, however, the cylindrical target portions 215 are formed of several individual cylinders placed around the outside surface of the target backing tube 205. The use of cylindrical target portions 215 is advantageous because it prevents stress build up and prevents the target material from cracking.

These cylindrical target portions 215 are generally formed of the same material and have flat side edges so that they can be compressed together laterally and present a uniform outside surface for sputtering. Additionally, the flat side edges prevent gaps from opening between the cylindrical target portions 215 and help to assure that the current is evenly distributed across the entire target surface. Note that the side edges can be angled to improve the fit between the cylindrical target portions 215.

In another embodiment, the side edges of the cylindrical target portion 215 are provided with a contour in the shape of a tongue and groove, at which the tongue of one cylindrical target portion 215 mates with the groove of the adjacent cylindrical target portion 215. In this way, there will remain little to no direct gap that may allow the plasma to attack the target backing tube 205. Other similar configurations could also be used.

The cylindrical target portions 215 can be slipped onto the target backing tube 205 by removing one stop. Because some target materials are subject to thermal expansion, a gap can be left between the cylindrical target portions 215 and at least one of the stops (220, 225). This gap(s) helps prevent cracking of the cylindrical target portions 215 due to expansion. This gap could also be filled with a compressible material that engages the stop (220, 225) and one of the cylindrical target portions 215.

In one embodiment of the present invention, the backing material 210 is eliminated and the target material 215 is allowed to directly contact the target backing tube 205. The water flow through the target backing tube 205 can be reduced to minimize any contact cooling between the target backing tube 205 and the cylindrical target portions 215. For example, the water flow could be reduced to the point where the magnets operate at a temperature just below their Curie temperature. In other embodiments, a special coolant with a higher boiling point than water, such as oil, can be used.

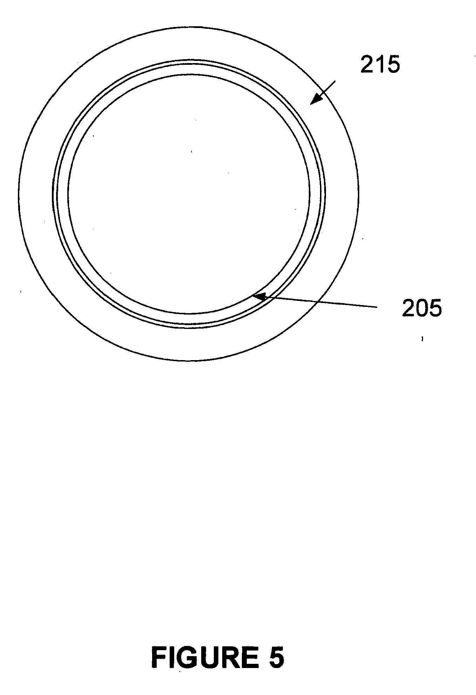

Referring now to Figure 5, it illustrates a cross section of one target assembly embodiment. This cross section shows a cylindrical target portion 215 fitted snuggly over the target backing tube 205. The actual sputterable material of the cylindrical target portion 215 could be in direct contact with the target backing tube 205.

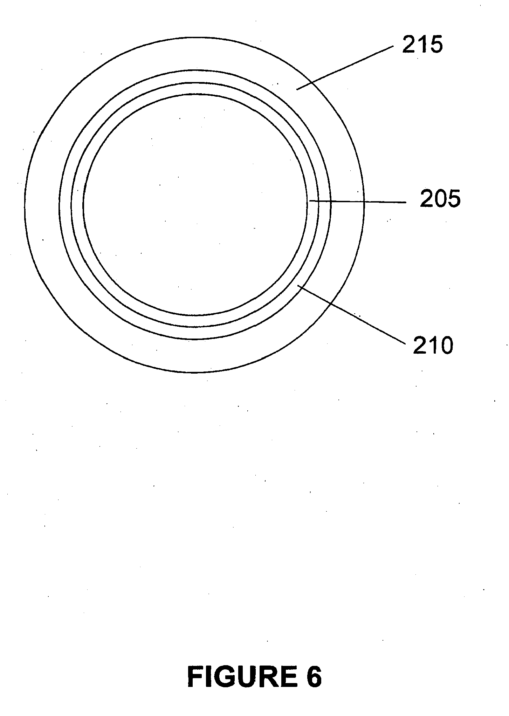

Referring now to Figure 6, it is a cross section of another target assembly embodiment where a mesh 210 is inserted between the cylindrical target portion 215 and the target backing tube 205. This embodiment promotes electrical conductivity and limits thermal conductivity.

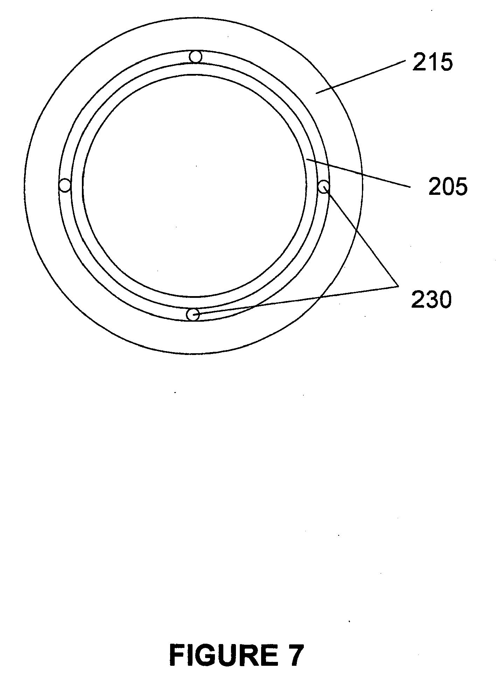

Figure 7 shows a cross section of yet another target assembly embodiment. This embodiment includes target spacers 230 located between the target backing tube 205 and the cylindrical target portions 215. Spacers are typically electrically conductive and may or may not be thermally conductive. And even if the spacers are thermally conductive, their spacing and limited surface will prevent significant thermal transfer between the target backing tube 205 and the cylindrical target portions 215. A typical spacer includes a metallic wire.

In another embodiment of the invention a separator is in contact with the exterior surface of the target backing tube 205. This separator may comprise a wire separator.

In conclusion, the present invention provides, among other things, non-bonded rotatable targets. Those skilled in the art can readily recognize that numerous variations and substitutions may be made in the invention, its use and its configuration to achieve substantially the same results as achieved by the embodiments described herein. Accordingly, there is no intention to limit the invention to the disclosed exemplary forms. Many variations, modifications and alternative constructions fall within the scope and spirit of the disclosed invention as expressed in the claims.

## Claims

1. A sputtering system comprising:
a target backing tube (205) having an exterior surface;
a backing layer (210) in contact with the exterior surface of the target backing tube (205), the backing layer (210) being electrically conductive and thermally non-conductive; and
a plurality of target cylinders (215) located around the target backing tube (205) and in contact with the backing layer.

2. The sputtering system of claim 1, wherein the target backing tube (205) comprises a first stop (225) and a second stop (220).

3. The sputtering system of claim 2, wherein the plurality of target cylinders (215) are positioned such that a gap exists between one of the plurality of target cylinders (215) and the first stop (225).

4. The sputtering system of claim 1, wherein at least two of the plurality of target cylinders (215) include flat edges that can be compressed together.

5. The sputtering system of claim 1, wherein the backing layer (210) comprises a mesh.

6. The sputtering system of claim 5, wherein the backing layer (210) comprises a graphite mesh.

7. The sputtering system of claim 1, wherein the backing layer (210) is attached to at least one of the plurality of target cylinders (215).

8. The sputtering system of claim 7, wherein the backing layer (210) is chemically attached to at least one of the plurality of target cylinders (215).

9. The sputtering system of claim 1, wherein each of the plurality of target cylinders (215) are formed of the same material.

10. A sputtering system comprising:
a plurality of target cylinders (215) having an outer surface and an inner surface; and
a mesh (210) attached to the inner surface of at least some of the plurality of target cylinders (215), the mesh layer (210) being electrically conductive and thermally non-conductive.

11. The sputtering system of claim 10, wherein the mesh comprises:
a plurality of separated mesh portions.

12. The sputtering system of claim 10, wherein the mesh comprises graphite.

13. The sputtering system of claim 10, wherein the plurality of target cylinders (215) are formed of an at least partially oxidized metal alloy.

14. The sputtering system of claim 10, wherein the plurality of target cylinders (215) are formed of ITO:

15. A sputtering system comprising:
a target backing tube (205) having an exterior surface;
a separator in contact with the exterior surface of the target backing tube (205); and
a plurality of target cylinders (215) located around the target backing tube (205) and in contact with the separator.

16. The sputtering system of claim 15, wherein the separator comprises a wire separator.

17. The sputtering system of claim 15, wherein at least some of the plurality of target cylinders (215) comprise:
a tongue and groove connection system.

18. The system of claim 15, further comprising a stop (220, 225) connected to the target backing tube (205).

19. The system of claim 18, wherein the stop comprises:
a tension spring configured to engage the stop (220, 225) and at least one of the plurality of target cylinders.

20. A rotatable magnetron system comprising:
a target backing tube (205) having an exterior surface;
a backing layer (210) in contact with the exterior surface of the target backing tube (205), the backing layer (210) being electrically conductive and thermally non-conductive;
a plurality of target cylinders (215) located around the target backing tube (205) and in contact with the backing layer (210);
a drive system (110) for rotating the target backing tube (205);
a magnet system located inside the target backing tube (205), the magnet system configure to maintain an enhanced sputter plasma; and
a cooling system (180) for cooling the target backing tube (205) and the magnet system.

21. The system of claim 20, further comprising a stop (220, 225) connected to the target backing tube (205).

22. The system of claim 21, wherein the plurality of target cylinders (215) are positioned such that a gap exists between one of the plurality of target cylinders (215) and the first stop (225).

23. The system of claim 22, wherein the stop comprises:
a tension spring configured to engage the stop and at least one of the plurality of target cylinders (215).

24. The system of claim 20, wherein at least some of the plurality of target cylinders (215) comprise:
a tongue and groove connection system.

25. The system of claim 20, wherein the backing layer is attached to at least one of the plurality of target cylinders (215).
